Europäisches Patentamt

European Patent Office

Office européen des brevets

(11) Veröffentlichungsnummer: **0 133 955**
**A1**

(12) **EUROPÄISCHE PATENTANMELDUNG**

(21) Anmeldenummer: **84108817.2**

(22) Anmeldetag: **25.07.84**

(51) Int. Cl.⁴: **H 01 L 23/54,** B 07 C 5/34

(30) Priorität: **29.07.83 DE 3327503**

(43) Veröffentlichungstag der Anmeldung: **13.03.85**
**Patentblatt 85/11**

(84) Benannte Vertragsstaaten: **AT DE FR GB IT**

(71) Anmelder: **Siemens Aktiengesellschaft, Berlin und München Wittelsbacherplatz 2, D-8000 München 2 (DE)**

(72) Erfinder: **Schindlbeck, Günter, Dipl.-Ing., Habichtstrasse 1a, D-8000 München 82 (DE)**

(54) Teststruktur zur Kennzeichnung von Halbleiterchips und Verfahren zu deren Kennzeichnung.

(57) Teststruktur zur Kennzeichnung von Halbleiterchips (1) bezüglich mindestens zweier bestimmter Merkmale, bestehend aus mindestens einem auf der Chipoberfläche angeordneten Kontaktflächenpaar mit den Kontaktflächen (2, 3), einem Parallelnetzwerk (4), beinhaltend mindestens zwei, elektrisch parallel geschaltete elektronische Bauelemente (14), und zwei Leitungen (5), die jeweils ein Ende des Parallelnetzwerkes (4) mit einer der beiden Kontaktflächen (2, 3) verbinden, sowie Verfahren zur Kennzeichnung von Halbleiterchips unter Verwendung erfindungsgemäßer Teststrukturen.

0133955

SIEMENS AKTIENGESELLSCHAFT                    Unser Zeichen
Berlin und München                           VPA  83 P 1524 E

Teststruktur zur Kennzeichnung von Halbleiterchips und
Verfahren zu deren Kennzeichnung

Die Erfindung betrifft eine Teststruktur zur Kennzeichnung
von Halbleiterchips gemäß dem Oberbegriff des Patentanspruchs 1
und ein Verfahren zur Durchführung der Kennzeichnung gemäß dem Oberbegriff des Patentanspruchs 14.

Die Notwendigkeit, Halbleiterchips noch auf der Halbleiterscheibe (wafer) im Verlaufe der einzelnen Fertigungsschritte, ggf. nach mehreren Merkmalen hin zu kennzeichnen,
besteht, seitdem Halbleiterbauelemente industriell gefertigt werden. So ist es beispielsweise üblich, integrierte Schaltkreise, wie z. B. Halbleiterspeicher,
noch vor dem Zerteilen der Wafer und dem Montieren in die
vorgesehenen Träger (z. B. Gehäuse) durch Anlegen von Meßspitzen an auf der Chipoberfläche angeordneten Kontaktflächen mittels eines Testautomaten zu prüfen und den
Halbleiterchip gemäß dem Testergebnis geeignet zu kennzeichnen. Solche zu kennzeichnenden Merkmale können beispielsweise sein: Ausschuß; verschiedene Zugriffszeitwerte bei integrierten Halbleiterspeichern; verschiedene
Zykluszeiten bei Mikroprozessoren; verschiedene, aktivierte, redundante Schaltungsteile innnerhalb von Halbleiterchips; verschiedene Spannungsfestigkeitswerte von
Leistungstransistoren.

Eine gängige Methode, Chips mit solchen Merkmalen zu
kennzeichnen, besteht darin, die zu kennzeichnenden Chips
auf ihrer Oberfläche im Bereich des aktiven Teils des

Ke 1 Hub / 19.07.1983

0133955

Chips mit Tintenflecken (ggf. mehreren, verschiedenfarbig) zu versehen ("inken"). Dabei treten bekanntermaßen bei guten, so gekennzeichneten Chips, die weiterverarbeitet werden sollen, diverse Schwierigkeiten auf:
Zuverlässigkeitsrisiken im aktiven Bereich auf der Chipoberfläche, Ausgasen der Tinte bei der Chipmontage und
vieles andere mehr.

Um diese Probleme zu umgehen, sieht beispielsweise
die DE-OS 31 22 984 für jedes zu kennzeichnende
Merkmal auf der Chipoberfläche eine Teststruktur
vor, bestehend aus einem Kontaktflächenpaar
und einer, diese beiden Kontaktflächen miteinander verbindenden Leiterbahn, die üblicherweise metallisiert ist.
Ist bei der Testdurchführung erkannt worden, welche Merkmale zu kennzeichnen sind, so wird anschließend jede dem
zu kennzeichnenden Merkmal zugeordnete Kombination
Leiterbahn-Kontaktflächenpaar (= Teststruktur) geeignet
unterbrochen. Nach Beendigung der Kennzeichnung ist dann
jedes Merkmal auf dem Chip auf folgende Art vermerkt:

a) Merkmal A        zutreffend:
   bei Teststruktur A Leiterbahn        unterbrochen;
b) Merkmal B nicht zutreffend:
   bei Teststruktur B Leiterbahn nicht unterbrochen.

Diese Ausführung der Teststrukturen hat den Nachteil,
für jedes zu kennzeichnende Merkmal eine eigene Teststruktur zu benötigen, was bei der Kennzeichnung mehrerer
Merkmale viel Platz auf dem Chip benötigt und, aufgrund
der Beschränkung der Pinanzahl beim jeweils verwendeten
Gehäusetyp, die Merkmale nicht mittels Bonding aus dem
Gehäuse heraus auf Pins führen zu können.

Aufgabe der vorliegenden Erfindung ist es, hier Abhilfe zu schaffen und eine Teststruktur zur Kennzeichnung sowie deren Durchführung bei Halbleiterchips vorzusehen, die es ermöglicht, die Verbindung zwischen zwei Kontaktflächen, die zur Kennzeichnung von Merkmalen dient, so zu gestalten, daß eine Teststruktur die Kennzeichnung von mehr als einem Merkmal aufnehmen kann, und die es auch ermöglicht, diese Kennzeichnung an entsprechenden Pins des fertig montierten Halbleiterbausteins jederzeit elektrisch erfassen zu können.

Diese Aufgabe wird bei einer Teststruktur der eingangs genannten Art erfindungsgemäß durch die Merkmale des kennzeichnenden Teils der Patentansprüche 1 und 14 gelöst.

Die Erfindung ist in vorteilhafter Weise anwendbar auf sämtliche bekannte integrierte Halbleiterbausteinarten, wie z. B. Halbleiterspeicher, Mikroprozessoren, Standardlogikbausteine, Gate Arrays in beliebiger Halbleitertechnologie. Ebenso ist sie vorteilhaft anwendbar auf Einzelhalbleiter, wie z. B. Leitstungstransistoren, um beispielsweise deren Spannungsfestigkeit auf dem Bauelement selbst zu dokumentieren.

Die Erfindung wird im foglenden anhand der Figuren 1 bis 4 näher erläutert. Es zeigen:

Fig. 1    eine schematische Darstellung einer erfindungsgemäßen Teststruktur;

Figuren 2a bis 2c  verschiedene Ausbildungen des Parallelnetzwerkes einer erfindungsgemäßen Teststruktur;

Fig. 3    eine Anordnung mit einem Schwellwertschalter, realisiert als Dickoxidtransistor, in einer der Verbindungsleitungen einer erfindungsgemäßen
Teststruktur, und

Fig. 4    eine Anordnung mit einer Diode in einer der
         Verbindungsleitungen einer erfindungsgemäßen
         Teststruktur.

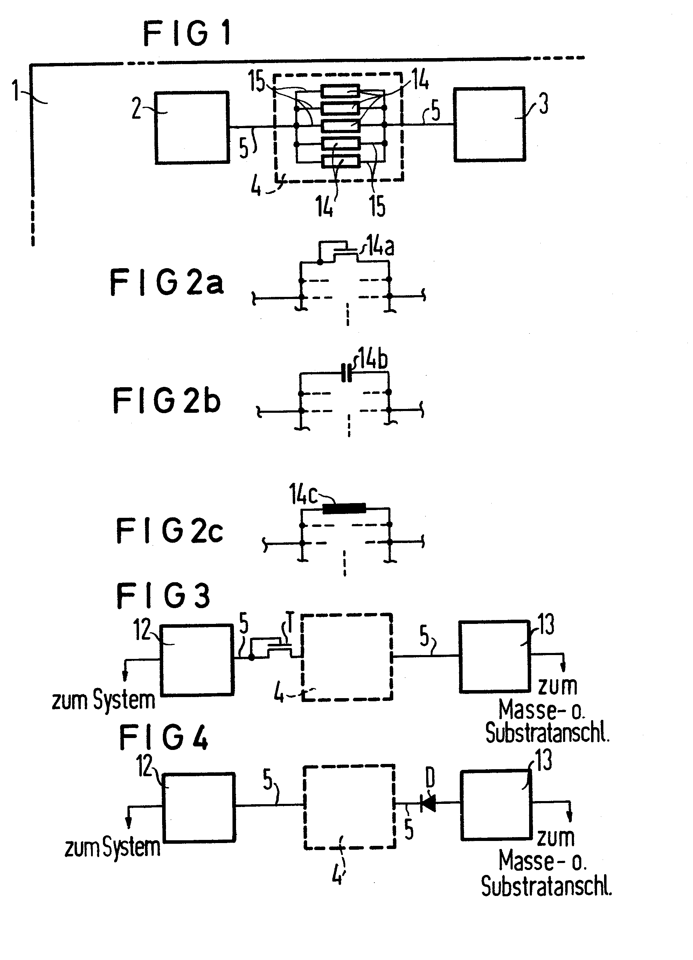

Fig. 1 stellt einen stark vergrößerten Ausschnitt aus
einem Halbleiterchip 1 dar, der an seinem Rande eine erfindungsgemäße Teststruktur enthält, wobei beispielsweise
das zwischen den beiden Anschlußpads 2,3 liegende
Parallelnetzwerk 4 durch eine frei wählbare Anzahl von
parallel geschalteten Widerständen 14 realisiert ist,
deren Werte beispielsweise 100 Ohm, 300 Ohm, 1 kOhm, 3 kOhm
und 10 kOhm sein können. Das eine Anschlußpad 2 ist ein
normalerweise unbenutztes Zusatzpad, wohingegen das andere
Anschlußpad 3 sowohl ein Zusatzpad als auch ein beliebiges
Anschlußpad der integrierten Schaltung sein kann.

In Fig. 2a sind die Widerstände 14 als Transistoren 14a
ausgebildet, die jeweils als Widerstand geschaltet sind.

In den Figuren 2b und 2c bilden anstelle der Widerstände
14 Kapazitäten 14b bzw. Induktivitäten 14c das Parallelnetzwerk 4.

Figuren 3 und 4 stellen weitere, erfindungsgemäße Ausbildungen dar, wobei jeweils das eine Anschlußpad 13 den
normalen Masse- oder Substratanschluß der integrierten
Schaltung bildet, das andere Pad 12 jedoch sowohl ein
Zusatzpad als auch ein normales, von der integrierten
Schaltung verwendetes Anschlußpad sein kann.

Allen erfindungsgemäßen Ausführungen liegt zugrunde, daß
das Auftrennen einzelner Leitungen des Parallelnetzwerkes
4 mit Mitteln erfolgt, die räumlich sehr eng begrenzt wirken. Ein solches Mittel ist beispielsweise: ein Laserstrahl, ein Elektronenstrahl, ein Ionenstrahl, Ultraschall. Dies hat den Vorteil, daß die zu kennzeichnende Schaltung in ihren räumlichen Abmessungen sehr klein gehalten werden kann.

Aus Fig. 1 ist zu entnehmen, daß mehrere Stromkreise unterschiedlicher Eigenschaften, wie z. B. Widerstandsleitungen mit unterschiedlichen Widerstandswerten, innerhalb des Parallelnetzwerkes 4 parallel geschaltet sind. Erfindungsgemäß können die ohmschen Widerstände auch durch andere Anordnungen realisiert sein, wie z. B. als Widerstand geschaltete Transistoren 14a, Blindwiderstände (Kapazitäten 14b, Induktivitäten 14c). Die Art der Realisierung ist nur für die die gekennzeichneten Merkmale auswertenden Anordnung (Meßschaltung) wichtig, die von an sich bekannter Art sein kann und die deshalb auch nicht dargestellt ist. Gegebenenfalls können die gekennzeichneten Merkmale auch rein optisch "ausgelesen" werden, z. B. mittels Mikroskop. An den mit 15 gekennzeichneten Stellen können die einzelnen Zweige des Parallelnetzwerkes 4 zum Zwecke der Kennzeichnung von Merkmalen aufgetrennt werden. Die Auftrennung kann z. B. mit Laserstrahlen, Ionenstrahlen, Elektronenstrahlen und Ultraschall durchgeführt werden. Für die mögliche Anzahl von Zuständen der Schaltung (im Beispiel: verschiedene Widerstandswerte) gibt es zwei Möglichkeiten:

a) Nur maximal ein Strompfad pro Parallelnetzwerk zulässig: Es ergeben sich $n+1$ Möglichkeiten bei $n$ verschiedenen Zweigen; im Beispiel: die sechs Werte 100 Ohm, 300 Ohm, 1 kOhm, 3 kOhm, 10 kOhm, $\infty$ bei fünf verschiedenen Zweigen.

b) Läßt man alle möglichen Kombinationen von Strompfaden zu, so ergeben sich rein rechnerisch $2^n$ Möglichkeiten,

die sich allerdings im Beispiel aufgrund der Berücksichtigung von fertigungstechnischen Toleranzen und meßtechnisch bedingten größeren Unterschiede zwischen den Meßwerten auf neun Wertebereiche reduzieren:

50 - 150 Ohm, 200 - 240 Ohm, 260 - 350 Ohm, 650 - 800 Ohm, 900 Ohm - 1 kOhm, $\approx$ 2,3 kOhm, 3 kOhm, 10 kOhm, $\infty$ .

Mindestens eines der in Fig. 1 dargestellten Anschlußpads 2, 3 ist ein Zusatzpad, das für den Betrieb des Halbleiterchips nicht benötigt wird.

Weitere, mögliche, vorteilhafte Ausführungen sind in den Figuren 3 und 4 aufgezeigt. Beide Ausführungen benötigen jeweils kein Zusatzpad, sondern benützen als den einen Anschluß ein normales Systemanschlußpad 12 und als den anderen Anschluß das Masseanschluß- oder Substratanschlußpad 13. Damit die Verbindungen zwischen den beiden Pads im Normalbetrieb des betroffenen Halbleiterbausteins nicht stören, sind beispielsweise zwei Varianten möglich:

1) nach Fig. 3 verhindert im Bereich der Leitung 5 ein Schwellwertschalter (z. B. Dickoxydtransistor T) im Normalbetrieb eine Beeinflussung der Teststruktur auf die an den beiden Pads 12, 13 sonst noch angeschlossenen Schaltungsteile des Halbleiterchips. Das Parallelschaltungsnetzwerk 4 wird nur bei Spannungen oberhalb der Betriebsspannung (Überspannung) an den Pads 12, 13 wirksam.

2) Nach Fig. 4 verhindert ein elektronisches Element D mit Diodencharakteristik im Bereich der Leitung 5 im Normalbetrieb störenden Einfluß des Parallelschaltungsblocks 4 auf den restlichen Halbleiterbaustein. Nach Umpolen der Spannungen an den Pads 12, 13 gegenüber der Polarität beim Normalbetrieb können jedoch

0133955

-7-    VPA  83 P 1524 E

die gekennzeichneten Merkmale meßtechnisch erfaßt
werden.

18 Patentansprüche
 4 Figuren

Patentansprüche

1. Teststruktur zur Kennzeichnung von Halbleiterchips (1) bezüglich mindestens zweier bestimmter Merkmale mit mindestens einem, zur elektronisch erfaßbaren Kennzeichnung auf der Chipoberfläche angeordneten Kontaktflächenpaar, dessen Kontaktflächen (2,3) elektrisch miteinander verbunden sind,
d a d u r c h   g e k e n n z e i c h n e t ,
daß die elektrische Verbindung aus einem Parallelnetzwerk (4), beinhaltend mindestens zwei, elektrisch parallel geschaltete elektronische Bauelemente (14) sowie zwei Leitungen (5) besteht, die jeweils ein Ende des Parallelnetzwerkes (4) mit einer der beiden Kontaktflächen (2,3) verbinden.

2. Teststruktur nach Anspruch 1,
d a d u r c h   g e k e n n z e i c h n e t ,
daß elektrisch erfaßbare Zustände des Parallelnetzwerkes (4) das Vorhandensein oder Nichtvorhandensein von verschiedenen, zu kennzeichnenden Merkmalen und deren Kombinationen angezeigt.

3. Teststruktur nach Anspruch 1 und 2,
d a d u r c h   g e k e n n z e i c h n e t ,
daß jeder der elektrisch erfaßbaren Zustände des Parallelnetzwerkes (4) auch optisch erkennbar ist.

4. Teststruktur nach einem der Ansprüche 1 bis 3,
d a d u r c h   g e k e n n z e i c h n e t ,
daß die parellel geschalteten elektronischen Bauelemente (14) des Parallelnetzwerkes (4) Widerstände sind.

5. Teststruktur nach einem der Ansprüche 1 bis 4,
d a d u r c h   g e k e n n z e i c h n e t ,
daß die Widerstände aus als Widerstand geschalteten Transistoren (14 a) bestehen.

0133955

6. Teststruktur nach einem der Ansprüche 1 bis 4,
d a d u r c h   g e k e n n z e i c h n e t ,
daß die Widerstände als hochohmige Leiterbahnen ausgebildet sind.

7. Teststruktur nach einem der Ansprüche 1 bis 3,
d a d u r c h   g e k e n n z e i c h n e t ,
daß die parallel geschalteten elektronischen Bauelemente
(14) des Parallelnetzwerkes (4) Kapazitäten (14b) sind.

8. Teststruktur nach einem der Ansprüche 1 bis 3,
d a d u r c h   g e k e n n z e i c h n e t ,
daß die parallelgeschalteten elektronischen Bauelemente (14)
des Parallelnetzwerkes (4) Induktivitäten (14c) sind.

9. Teststruktur nach einem der Ansprüche 1 bis 8,
d a d u r c h   g e k e n n z e i c h n e t ,
daß mindestens eine der beiden Kontaktflächen (2,3) eines
oder mehrerer der zur Kennzeichnung von Merkmalen verwendeten Kontaktflächenpaare als Zusatzpad ausgebildet
ist, das zum Betrieb der elektronischen Schaltung des zu
kennzeichnenden Halbleiterchips nicht benötigt wird.

10. Teststruktur nach einem der Ansprüche 1 bis 8,
d a d u r c h   g e k e n n z e i c h n e t ,
daß jeweils eine der beiden Kontaktflächen (13) eines zur
Kennzeichnung von Merkmalen verwendeten Kontaktflächenpaares das Masse- oder Substratanschlußpad des Halbleiterchips ist, und daß die andere Kontaktfläche (12) ein
anderes, beliebiges Anschlußpad des Halbleiterchips ist.

11. Teststruktur nach einem der Ansprüche 1 bis 8 mit
mindestens einem Kontaktflächenpaar nach Anspruch 10,
d a d u r c h   g e k e n n z e i c h n e t ,
daß im Verlaufe einer der beiden Leitungen (5) ein Schwellwertschalter (T) angeordnet ist, der die Auswertung der der auf dem Chip gekennzeichneten Merkmale nur bei größeren Spannungen als den üblichen, zum Betrieb des Chips an die Anschlußflächen (12,13) angelegten Spannungen ermöglicht.

12. Teststruktur nach Anspruch 11,
d a d u r c h   g e k e n n z e i c h n e t ,
daß der Schwellwertschalter (T) als Dickoxidtransistor ausgebildet ist.

13. Teststruktur nach einem der Ansprüche 1 bis 8 mit mindestens einem Kontaktflächenpaar nach Anspruch 10,
d a d u r c h   g e k e n n z e i c h n e t ,
daß im Verlaufe einer der beiden Leitungen (5) ein elektronisches Bauelement (D) mit Diodencharakteristik angeordnet ist, daß die Auswertung der auf dem Chip gekennzeichneten Merkmale nur bei einer Spannungspolarität zwischen den beiden Anschlußflächen (12,13) ermöglicht, die der Spannungspolarität an diesen beiden Anschlußflächen (12,13) beim üblichen Betrieb des Halbleiterbausteins entgegengesetzt ist.

14. Verfahren zur Kennzeichnung von Halbleiterchips unter Verwendung mindestens einer Teststruktur gemäß einem der Ansprüche 1 bis 13,
d a d u r c h   g e k e n n z e i c h n e t ,
daß zur Einbringung der zu kennzeichnenden Merkmale in die Teststruktur Parallelleitungszweige (15) des Parallelnetzwerkes (4) durchtrennt werden.

15. Verfahren nach Anspruch 14,
d a d u r c h   g e k e n n z e i c h n e t ,
daß die Durchtrennung mit Hilfe von Korpuskularstrahlen erfolgt.

16. Verfahren nach Anspruch 14,
d a d u r c h   g e k e n n z e i c h n e t ,
daß die Durchtrennung mit Hilfe von Laserstrahlen
erfolgt.

17. Verfahren nach Anspruch 14,
d a d u r c h   g e k e n n z e i c h n e t ,
daß die Durchtrennung mit Hilfe von Elektronenstrahlen
erfolgt.

18. Verfahren nach Anspruch 14,
d a d u r c h   g e k e n n z e i c h n e t ,
daß die Durchtrennung mit Hilfe von Ultraschall erfolgt.

FIG 1

FIG 2a

FIG 2b

FIG 2c

FIG 3

zum System

zum
Masse- o.
Substratanschl.

FIG 4

zum System

zum
Masse- o.
Substratanschl.

**Europäisches Patentamt**

# EUROPÄISCHER RECHERCHENBERICHT

0133955

## EINSCHLÄGIGE DOKUMENTE

| Kategorie | Kennzeichnung des Dokuments mit Angabe, s we rforderlich, der maßgeblichen Teile | Betrifft Anspruch | KLASSIFIKATION DER ANMELDUNG (Int Cl. ³) |
|---|---|---|---|
| A,D | EP-A-0 066 836 (SIEMENS) <br> * Zusammenfassung * <br><br> --- | 1,14 | H 01 L 23/54 <br> B 07 C 5/34 |
| A | EP-A-0 057 645 (FAIRCHILD) <br> * Figur 2; Zusammenfassung * <br><br> --- | 1,14 | |
| A | US-A-4 344 064 (J.R. BITLER et al.) <br> * Figur 2; Zusammenfassung * <br><br> --- | 1,14 | |
| A | US-A-3 678 251 (F.H. DELPINO) <br><br> * Figur 1A; Zusammenfassung * <br><br> ----- | | |

**RECHERCHIERTE SACHGEBIETE (Int. Cl. ³)**

B 07 C
G 06 K
H 01 L

Der vorliegende Recherchenbericht wurde für alle Patentansprüche erstellt.

| Recherchenort <br> DEN HAAG | Abschlußdatum der Recherche <br> 15-10-1984 | Prüfer <br> MIELKE W |
|---|---|---|